# EUROPEAN PATENT APPLICATION

(11) **EP 3 264 862 A1**
(43) Date of publication of application: **03.01.2018**
(21) Application number: 16755324.7
(22) Date of filing: 18.02.2016
(51) Int. Cl.: H05B 33/04, F21S 2/00, F21V 23/00, F21V 31/00, H01L 51/50, H05B 33/06, H05B 33/08, F21Y 115/15

(54) **PLANAR LIGHT-EMITTING MODULE**

(30) Priority: 26.02.2015 JP 2015036694
(71) Applicant: Konica Minolta, Inc., Tokyo 100-7015 (JP)
(72) Inventor: NAITO, Mitsuyoshi, Tokyo 100-7015 (JP); SANDO, Yasuhiro, Tokyo 100-7015 (JP)
(74) Representative: Henkel, Breuer & Partner
(86) International application number: PCT/JP2016/054675
(87) International publication number: WO 2016/136577

(57) **Abstract**

A planar light-emitting module (100) includes a sealing sheet (21) having an opening (21L), a sealing sheet (22), a planar light-emitting element (10) sealed by the sealing sheets (21, 22), and a wiring member (30) disposed between the sealing sheets (21, 22). The wiring member (30) includes an electrode (33) having an exposed portion (33L) disposed so as to be exposable from the opening (21L) of the sealing sheet (21) and a protective film (34) having an aperture (34L) corresponding to the exposed portion (33L). An edge portion that forms the opening (21L) in the sealing sheet (21) is located outside the aperture (34L) and located on a portion having a flat shape in a surface of the protective film (34). The planar light-emitting module (100) can suppress reduction of sealing performance due to the presence of the wiring member.

## Description

### Technological Field

The present invention relates to a planar light-emitting module including a sheet for sealing a planar light-emitting element.

### Background

A planar light-emitting element is formed with a thin planar light source such as organic EL. Planar light-emitting modules including planar light-emitting elements are installed both indoors and outdoors and utilized in a wide variety of applications such as signage, signs, backlights, lighting, and illumination. The planar light-emitting elements require protection from dust, ultraviolet rays, and weather. In general, the planar light-emitting element is disposed between a pair of sheets and sealed so as to be sandwiched between the pair of sheets (for example, see PTDs 1, 2 below).

In the organic EL device disclosed in PTD 1 (Japanese Laid-Open Patent Publication No. 2010-244698), a pair of sealing sheets are bonded to each other using adhesive with a wiring member disposed between the end portions of the pair of sealing sheets (in other words. with a wiring member interposed between the end portions of the pair of sealing sheets). The end portions of the pair of sealing sheets have steps due to the presence of the wiring member, and the adhesive is affected by the steps and fails to fulfill sufficient adhesion performance. The invention disclosed in PTD 1 prevents reduction in sealing performance by filling the gap formed between the pair of sealing sheets and the organic EL panel and the gap formed between the pair of sealing sheets and the wiring member with sealing resin.

In the electroluminescence light disclosed in Japanese Laid-Open Patent Publication No. H01-117295 (PTD 2), a planar light-emitting element and electrode lead terminals are sealed by a pair of films, conductors (electrode pins) are inserted from the outside of one of the films, and the inserted ends of the conductors are connected to the electrode lead terminals. The outer ends of the conductors protrude outward of the film, and the planar light-emitting element is fed through the protruding portions. According to the description in PTD 2, high sealing performance can be achieved because the entire planar light-emitting element and the entire electrode lead terminals can be sealed without exposing the electrode lead terminals on the outside.

### Citation List

### Patent Document

PTD 1: Japanese Laid-Open Patent Publication No. 2010-244698
PTD 2: Japanese Laid-Open Patent Publication No. H01-117295

### Summary

### Technical Problem

When the configuration disclosed in PTD 1 (Japanese Laid-Open Patent Publication No. 2010-244698) is employed, that is, when the end portions of a pair of sealing sheets are to be bonded with a wiring member interposed between the end portions of the pair of sealing sheets, a gap is easily formed between the end portions of the pair of sealing sheets due to the presence of the wiring member (step) and therefore, it is not easy to achieve sufficient sealing performance.

When the configuration disclosed in Japanese Laid-Open Patent Publication No. H01-117295 (PTD 2) is employed, the insertion of the conductor (electrode pin) causes breakage of part of the sealing sheet. The sealing sheet may be further broken from the broken part, and it is not easy to keep reliable sealing performance for a long time.

The present invention is made in view of the foregoing situation and is aimed to provide a planar light-emitting module having a configuration that can suppress reduction of sealing performance due to the presence of a wiring member.

### Solution to Problem

A planar light-emitting module based on an aspect of the present invention includes a first sealing sheet having an opening, a second sealing sheet bonded to the first sealing sheet, a planar light-emitting element disposed between the first sealing sheet and the second sealing sheet and sealed by the first sealing sheet and the second sealing sheet, and a wiring member disposed between the first sealing sheet and the second sealing sheet and electrically connected to the planar light-emitting element. The wiring member includes a substrate, an electrode formed on the substrate and having an exposed portion disposed so as to be exposable from the opening of the first sealing sheet, and a protective film having an aperture corresponding to the exposed portion and provided so as to cover at least periphery of the exposed portion of the electrode. One exposed portion described above is exposable through one opening and one aperture described above. An edge portion that forms the opening in the first sealing sheet is located outside the aperture and located on a portion having a flat shape in a surface of the protective film.

A planar light-emitting module based on another aspect of the present invention includes a first sealing sheet having an opening, a second sealing sheet bonded to the first sealing sheet, a planar light-emitting element disposed between the first sealing sheet and the second sealing sheet and sealed by the first sealing sheet and the second sealing sheet, and a wiring member disposed between the first sealing sheet and the second sealing sheet and electrically connected to the planar light-emitting element. The wiring member includes a substrate and an electrode formed on the substrate and having an exposed portion disposed so as to be exposable from the opening of the first sealing sheet. One exposed portion described above is exposable through one opening described above. An edge portion that forms the opening in the first sealing sheet is located on a portion having a flat shape in a surface of the electrode.

### Brief Description of the Drawings

Fig. 1 is a plan view showing a planar light-emitting module in a first embodiment.
Fig. 2 is a plan view showing the planar light-emitting module in the first embodiment in an exploded state.
Fig. 3 is a plan view showing the planar light-emitting module in the first embodiment in a further exploded state.
Fig. 4 is a cross-sectional view taken along the line IV-IV in Fig. 3.
Fig. 5 is a plan view for explaining the operation and effects of the planar light-emitting module in the first embodiment.
Fig. 6 is a plan view showing a planar light-emitting module in a comparative example.
Fig. 7 is a plan view showing the planar light-emitting module in the comparative example in an exploded state.
Fig. 8 is a plan view for explaining the operation and effects of the planar light-emitting module in the comparative example.

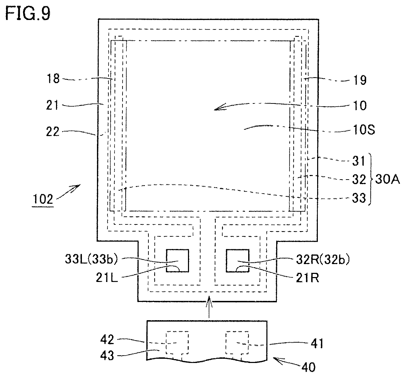

Fig. 9 is a plan view showing a planar light-emitting module in a second embodiment.
Fig. 10 is a plan view showing the planar light-emitting module in the second embodiment in an exploded state.
Fig. 11 is a plan view for explaining the operation and effects of the planar light-emitting module in the second embodiment.

### Detailed Description of Embodiments

Embodiments will be described below with reference to the drawings. The same parts and corresponding parts are denoted with the same reference numerals and an overlapping description may not be repeated.

### [First Embodiment]

### (Planar Light-Emitting Module 100)

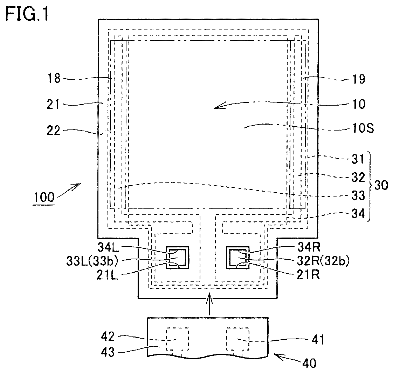

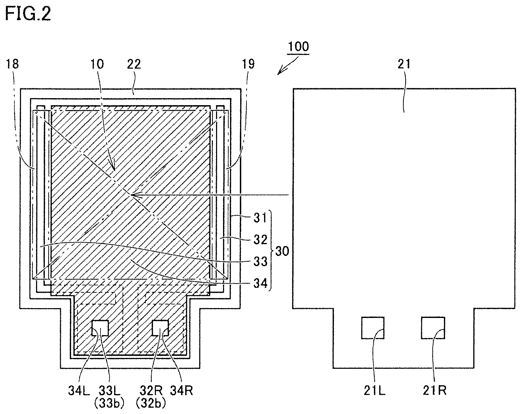

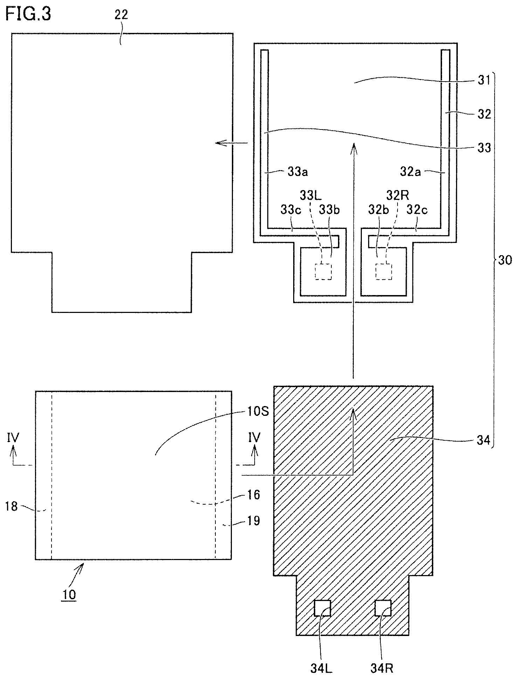

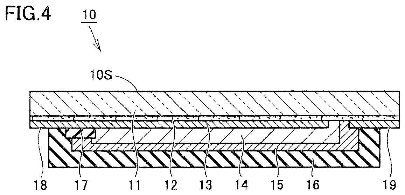

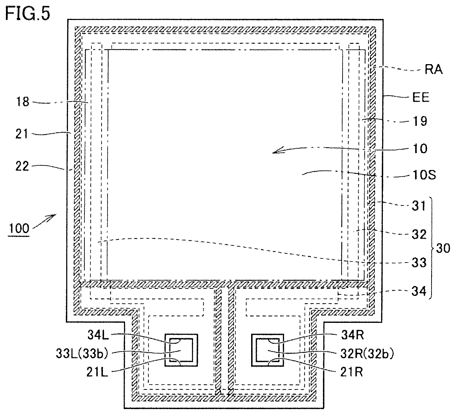

Referring to Fig. 1 to Fig. 5, a planar light-emitting module 100 in a first embodiment will be described. Fig. 1 is a plan view showing planar light-emitting module 100, Fig. 2 is a plan view showing planar light-emitting module 100 in an exploded state, Fig. 3 is a plan view showing planar light-emitting module 100 in a further exploded state, and Fig. 4 is a cross-sectional view taken along the line IV-IV in Fig. 3. Fig. 5 is a plan view for explaining the operation and effects of planar light-emitting module 100.

Planar light-emitting module 100 is connected with, for example, external wiring 40 (see Fig. 1), and planar light-emitting module 100 can be used in various applications such as lighting, decoration, and backlights. External wiring 40 is formed of, for example, FPC and includes contact portions 41, 42 and a substrate 43 for holding them. As will be detailed later, contact portions 41, 42 are connected to feeding portions 32R, 33L (exposed portion), respectively, of planar light-emitting module 100 through not-shown conductive adhesive (ACF).

Planar light-emitting module 100 is configured such that a planar light-emitting element 10 is sandwiched between and sealed by a pair of sealing sheets 21, 22 (Fig. 1, Fig. 2) from above and below. For the sake of convenience, Fig. 2 shows planar light-emitting element 10 using a dashed and double-dotted line, and Fig. 3 does not show sealing sheet 21. More specifically, planar light-emitting module 100 includes planar light-emitting element 10, a pair of sealing sheet 21 (first sealing sheet) and sealing sheet 22 (second sealing sheet) holding planar light-emitting element 10 from above and below, and a wiring member 30 electrically connected to planar light-emitting element 10 for feeding planar light-emitting element 10. They will be described one by one below.

### (Planar Light-Emitting Element 10)

As shown in Fig. 1 to Fig. 4 (mainly Fig. 3 and Fig. 4), planar light-emitting element 10 is formed of organic EL and disposed between sealing sheet 21 and sealing sheet 22. Planar light-emitting element 10 is disposed such that a front surface 10S (light-emitting surface) is positioned on the side on which sealing sheet 21 is disposed (the front side of the drawing sheet of Fig. 2). The thickness of planar light-emitting element 10 is, for example, 50 µm to 200 µm. It is preferable that planar light-emitting element 10 has flexibility. Planar light-emitting element 10 in the present embodiment has a rectangular shape in a two-dimensional view (see Fig. 3).

As shown in Fig. 4. planar light-emitting element 10 includes a transparent substrate 11, a barrier layer 12, an anode 13, an emissive layer 14, a cathode 15, a sealing member 16, and an insulating layer 17. Transparent substrate 11, barrier layer 12, anode 13, emissive layer 14, cathode 15, and sealing member 16 are stacked in order from the front surface 10S (light-emitting surface) side of planar light-emitting element 10 toward the back surface side of planar light-emitting element 10.

Transparent substrate 11 is formed of glass, thin film glass, resin film, or the like. Transparent substrate 11 is a member that forms front surface 10S of planar light-emitting element 10 and has a rectangular shape in a two-dimensional view. Barrier layer 12 has transparency and is formed to cover the whole of the surface of transparent substrate 11. Barrier layer 12 is formed of, for example, a silicon compound such as silicon oxide and silicon nitride or a metal compound such as metal oxide and metal nitride, or a mixture thereof.

Anode 13 is a conductive film having transparency and is formed by depositing ITO or the like on barrier layer 12. An ITO film for forming anode 13 is divided into two regions by patterning to form a feeding portion 18 (for anode) and a feeding portion 19 (for cathode). The ITO film that forms feeding portion 19 is connected to cathode 15.

When supplied power, emissive layer 14 produces light by the action of field effect. Emissive layer 14 is formed with a single layer or a plurality of stacked layers. Cathode 15 is, for example, aluminum (Al) and is formed to cover emissive layer 14. Insulating layer 17 is provided between cathode 15 and anode 13. A portion of cathode 15 that is opposite to the side on which insulating layer 17 (Fig. 3) is located is connected to the ITO film that forms feeding portion 19.

Sealing member 16 is formed of glass, thin film glass, resin film, or the like. Sealing member 16 seals almost the whole of anode 13, emissive layer 14, and cathode 15 on transparent substrate 11 (on barrier layer 12). Part of the ITO film formed on barrier layer 12 is exposed from sealing member 16 to form feeding portions 18, 19 (portions where electrical connection is made). Feeding portions 18, 19 are located on the outside of sealing member 16 and located opposite to each other with respect to sealing member 16 (emissive layer 14).

In planar light-emitting element 10 configured as described above, power is fed through wiring member 30 (which will be detailed later), feeding portions 18. 19, anode 13. and cathode 15 to emissive layer 14. Light is produced in emissive layer 14. and the light passes through anode 13, barrier layer 12, and transparent substrate 11 and is extracted from front surface 10S of planar light-emitting element 10.

### (Sealing Sheets 21, 22)

Referring to Fig. 1 to Fig. 3, a pair of sealing sheet 21 and sealing sheet 22 are bonded to each other to seal planar light-emitting element 10 in the inside thereof. For example, a resin member having a sheet shape or a film shape is used as sealing sheets 21, 22. It is preferable that sealing sheets 21, 22 have flexibility. The thickness of sealing sheets 21, 22 is, for example, 25 µm to 50 µm.

Examples of the specific material of sealing sheets 21, 22 include polyethylene terephthalate, polypropylene, acrylic, polyimide, and polysulfone. In addition to these materials, a variety of films deposited for improving the barrier characteristic may be used for sealing sheets 21, 22. The color of sealing sheets 21, 22 is not limited, and at least sealing sheet 21 of sealing sheets 21. 22 has high transparency to allow light emitted from front surface 10S of planar light-emitting element 10 to pass through. Sealing sheet 22 may also have transparency.

Adhesive (not shown) is provided on the inside surfaces of sealing sheets 21, 22 to bond sealing sheets 21, 22. For example, a variety of materials such as thermoplastic resin, thermosetting resin, and UV curable resin can be used as adhesive. The thickness of adhesive is, for example, 20 µm to 50 µm.

As shown in Fig. 2, sealing sheets 21. 22 have a rectangular portion larger than the area of planar light-emitting element 10. Wiring member 30 described later (substrate 31, electrodes 32, 33, and protective film 34) is disposed on the rectangular portion of sealing sheet 22. Planar light-emitting element 10 is placed on wiring member 30 (protective film 34) such that sealing member 16 of planar light-emitting element 10 (see Fig. 4) overlaps protective film 34 of wiring member 30. Wiring member 30 includes electrodes 32, 33, and electrodes 32, 33 (linear portions 32a, 33a) are electrically connected to feeding portions 19, 18 of planar light-emitting element 10, respectively.

As shown in Fig. 1 and Fig. 2, sealing sheet 21 has a pair of openings 21L, 21R (Fig. 2). The position of opening 21L corresponds to the position of feeding portion 33L of wiring member 30 and the position of aperture 34L provided in protective film 34 of wiring member 30 (see Fig. 1). Specifically, when planar light-emitting element 10 and wiring member 30 are sandwiched and sealed between a pair of sealing sheets 21, 22 from above and below, feeding portion 33L is located on the inside of aperture 34L, and feeding portion 33L and aperture 34L are located on the inside of opening 21L when feeding portion 33L. aperture 34L, and opening 21L are viewed from the direction parallel to the direction in which planar light-emitting element 10, wiring member 30, and sealing sheets 21, 22 arc superimposed on each other (when viewed two-dimcnsionally).

The position of opening 21R corresponds to the position of feeding portion 32R of wiring member 30 and the position of aperture 34R provided in protective film 34 of wiring member 30. Specifically, when planar light-emitting element 10 and wiring member 30 are sandwiched and sealed between a pair of sealing sheets 21, 22 from above and below, feeding portion 32R is located on the inside of aperture 34R, and feeding portion 32R and aperture 34R are located on the inside of opening 21R when feeding portion 32R, aperture 34R, and opening 21R are viewed from the direction parallel to the direction in which planar light-emitting element 10, wiring member 30, and sealing sheets 21, 22 are superimposed on each other (when viewed two-dimensionally). Further detail of openings 21L, 21R will be described later.

### (Wiring Member 30)

Referring to Fig. 3, wiring member 30 is electrically connected to planar light-emitting element 10 and is disposed between sealing sheets 21 and 22. Specifically, wiring member 30 includes a substrate 31, electrodes 32, 33, and a protective film 34. It is preferable that wiring member 30 has flexibility as a whole. Substrate 31 and protective film 34 (coverlay) have an outer shape smaller than sealing sheets 21, 22. Protective film 34 has a pair of apertures 34L, 34R. Protective film 34 is provided so as to cover at least the portions located around feeding portions 32R, 33L (exposed portions) in electrodes 32, 33 and serves to protect electrodes 32, 33 and improve the sealing performance for the electrodes.

Electrodes 32, 33 are formed on substrate 31 by a deposition technique such as printing, vapor deposition, plating and sputtering. The thickness of electrodes 32, 33 is, for example, 0.1 µm to 10 µm. The material of electrodes 32, 33 is, for example, copper or nickel, or a laminate thereof. In addition to copper or nickel, or a laminate thereof, the surface thereof may be plated with gold. Electrodes 32, 33 may not be deposited but may be formed by affixing a metal thin foil such as copper foil tape on the surface of substrate 31 using conductive adhesive (for example, ACF: anisotropic conductive film).

### (Electrode 32)

Electrode 32 includes a linear portion 32a extending longitudinally to match with the position and shape of feeding portion 19 of planar light-emitting element 10, a rectangular portion 32b having feeding portion 32R (exposed portion) inside thereof, and a connecting portion 32c connecting linear portion 32a with rectangular portion 32b. When protective film 34 is disposed on substrate 31 and electrodes 32. 33, linear portion 32a is not covered with protective film 34. Feeding portion 19 of planar light-emitting element 10 is electrically connected to linear portion 32a of electrode 32 through not-shown conductive adhesive (ACF). Feeding portion 19 of planar light-emitting element 10 may be pressure-welded to linear portion 32a of electrode 32 without using conductive adhesive (ACF).

Feeding portion 32R is a portion of electrode 32 that is exposable through aperture 34R when protective film 34 is disposed on substrate 31 and electrode 32. That is, feeding portion 32R (exposed portion) is a portion that is disposed to be exposable on the outside through aperture 34R and opening 21R and connected to contact portion 41 of external wiring 40 (Fig. 1) when protective film 34, planar light-emitting element 10, and sealing sheet 21 are disposed in order on electrode 32. As used herein "exposable" is a concept that includes not only the state in which feeding portion 32R is actually exposed through aperture 34R and opening 21R but also the state in which feeding portion 32R in that state is further covered with another sealing member or conductive paste as necessary and not exposed.

The position of aperture 34R provided in protective film 34 corresponds to the position of feeding portion 32R of wiring member 30 (electrode 32) and the position of opening 21R provided in sealing sheet 21 (see Fig. 1). The size of aperture 34R is smaller than the size of opening 21R (the aperture area is smaller). The size of opening 21R is smaller than the size of rectangular portion 32b of electrode 32. Therefore, in the state in which protective film 34, planar light-emitting element 10, and sealing sheet 21 are disposed in order on electrode 32, the edge portion that forms opening 21R in sealing sheet 21 is located outside the position of aperture 34R and located on a portion having a flat shape in the surface of protective film 34 (located on rectangular portion 32b with protective film 34 interposed).

Protective film 34 (specifically, the portion around aperture 34R in protective film 34) is disposed on the surface of the portion located around feeding portion 32R in rectangular portion 32b (Fig. 3). The portion around aperture 34R in protective film 34 is bonded to sealing sheet 21 through adhesive (see Fig. 2). If the bonding force between protective film 34 and sealing sheet 21 is high, the sealing performance of planar light-emitting module 100 can be improved. Therefore, it is preferable that the portion located around feeding portion 32R in rectangular portion 32b has a surface shape that has little or no step and is as flat as possible (with highest possible flatness).

### (Electrode 33)

Electrode 33 includes a linear portion 33a extending longitudinally so as to match with the position and shape of feeding portion 18 of planar light-emitting element 10, a rectangular portion 33b having a feeding portion 33L (exposed portion) inside thereof, and a connecting portion 33c connecting linear portion 33a with rectangular portion 33b. When protective film 34 is disposed on substrate 31 and electrodes 32, 33, linear portion 33a is not covered with protective film 34. Feeding portion 18 of planar light-emitting element 10 is electrically connected to linear portion 33a of electrode 33 through not-shown conductive adhesive (ACF). Feeding portion 18 of planar light-emitting element 10 may be pressure-welded to linear portion 33a of electrode 33 without using conductive adhesive (ACF).

Feeding portion 33L is a portion of electrode 33 that is exposable through aperture 34L when protective film 34 is disposed on substrate 31 and electrode 33. That is, feeding portion 33L (exposed portion) is a portion that is disposed so as to be exposable on the outside through aperture 34L and opening 21L and connected to contact portion 42 of external wiring 40 (Fig. 1) when protective film 34, planar light-emitting element 10. and sealing sheet 21 are disposed in order on electrode 33. As used herein "exposable" is a concept that includes not only the state in which feeding portion 33L is actually exposed through aperture 34L and opening 21L but also the state in which feeding portion 33L in that state is further covered with another sealing member or conductive paste as necessary and not exposed.

The position of aperture 34L provided in protective film 34 corresponds to the position of feeding portion 33L of wiring member 30 (electrode 33) and the position of opening 21L provided in sealing sheet 21 (see Fig. 1). The size of aperture 34L is smaller than the size of opening 21L (the aperture area is smaller). The size of opening 21L is smaller than the size of rectangular portion 33b of electrode 33. Therefore, in the state in which protective film 34, planar light-emitting element 10, and sealing sheet 21 are disposed in order on electrode 33, the edge portion that forms opening 21L in sealing sheet 21 is located outside aperture 34L and is located on a portion having a flat shape in the surface of protective film 34 (located on rectangular portion 33b with protective film 34 interposed).

Protective film 34 (specifically, the portion around aperture 34L in protective film 34) is disposed on the surface of the portion located around feeding portion 33L in rectangular portion 33b (Fig. 3). The portion around aperture 34L in protective film 34 is bonded to sealing sheet 21 through adhesive (see Fig. 2). If the bonding force between protective film 34 and sealing sheet 21 is high, the sealing performance of planar light-emitting module 100 can be improved. Therefore, it is preferable that the portion located around feeding portion 33L in rectangular portion 33b has a surface shape that has little or no step and is as flat as possible (with highest possible flatness).

In the present embodiment, electrode 32 and electrode 33 of wiring member 30 extend on the same side of planar light-emitting element 10, and feeding portions 32R, 33L (rectangular portions 32b, 33b) are disposed to be adjacent to each other.

### (Operation and Effects)

Referring to Fig. 5, in planar light-emitting module 100, feeding portions 33L, 32R of electrodes 33, 32 are exposed through apertures 34L, 34R provided in protective film 34 and openings 21L, 21R provided in sealing sheet 21 (first sealing sheet), respectively. Contact portions 42, 41 of external wiring 40 (Fig. 1) can be electrically connected to feeding portions 33L. 32R, respectively. External wiring 40 is not positioned between the end portions of sealing sheets 21, 22.

Unlike the case of PTD I (Japanese Laid-Open Patent Publication No. 2010-244698) mentioned earlier, in planar light-emitting module 100, the presence of external wiring 40 does not result in formation of steps between the end portions of the sealing sheets 21, 22, and the presence of external wiring 40 hardly affects the sealing performance. The end portions of sealing sheets 21, 22 can be bonded to each other appropriately, and the sealing performance can be obtained with sealing sheets 21, 22.

Region RA shown by a hatching in Fig. 5 is located around planar light-emitting element 10, around substrate 31, or around protective film 34. This region RA indicates a portion where it is more likely than other portions that the thickness of planar light-emitting element 10, the thickness of electrodes 32, 33, and the thickness of protective film 34 produce steps when sealing sheets 21, 22 are bonded, and the presence of the steps results in a gap. If this region RA reaches outer edge EE (Fig. 5) or openings 21L, 21R of sealing sheets 21, 22, moisture or other substances easily intrude through the portion where region RA reaches. Planar light-emitting module 100 in the present embodiment, however, is not configured as such.

More specifically, when sealing sheet 21 is bonded to sealing sheet 22, the portions around apertures 34L, 34R in protective film 34 are bonded to sealing sheet 21 through adhesive (see Fig. 2). The edge portion that forms opening 21L in sealing sheet 21 is located outside the position of aperture 34L and located on a portion having a flat shape in the surface of protective film 34 (located on rectangular portion 33b with protective film 34 interposed). Similarly, the edge portion that forms opening 21R in sealing sheet 21 is located outside the position of aperture 34R and located on a portion having a flat shape in the surface of protective film 34 (located on rectangular portion 32b with protective film 34 interposed). Since a sealing structure that contains region RA in the inside by bonding between flat surfaces is thus achieved, it can be said that reduction of sealing performance is suppressed compared with the conventional sealing structure.

Unlike the case of Japanese Laid-Open Patent Publication No. H01-117295 (PTD 2) mentioned earlier, planar light-emitting module 100 does not employ a configuration having a conductor (electrode pin) inserted (pierced) into the scaling sheet. Compared with the case of PTD 2, the possibility that the scaling sheet is broken is low, and reliable sealing performance can be kept for a long time compared with the case of PTD 2.

### [Comparative Example]

### (Planar Light-Emitting Module 101)

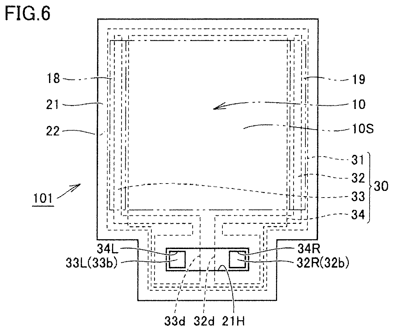

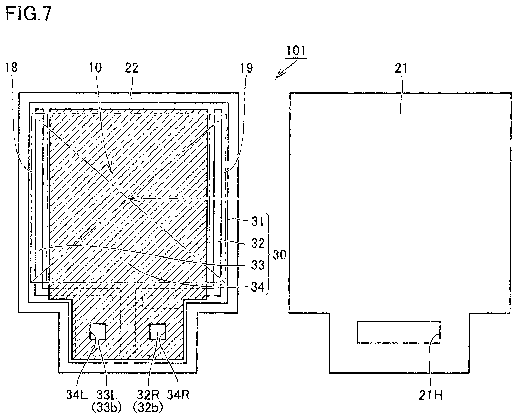

Referring to Fig. 6 to Fig. 8, a planar light-emitting module 101 in a comparative example will be described. Planar light-emitting module 101 differs from planar light-emitting module 100 of the first embodiment in that one opening 21H is provided in sealing sheet 21.

The edge portion that forms opening 21H in sealing sheet 21 is located outside apertures 34L, 34R provided in protective film 34 (Fig. 6). However, the edge portion that forms opening 21H in sealing sheet 21 is not located on a portion having a flat shape in the surface of protective film 34. Steps 32d, 33d (Fig. 6) are formed on protective film 34 due the presence of electrodes 32, 33 (rectangular portions 32b, 33b). The edge portion that forms opening 21H in sealing sheet 21 is disposed to extend across steps 32d, 33d (disposed to cross steps 32d, 33d) and is not located on a portion having a flat shape in the surface of protective film 34.

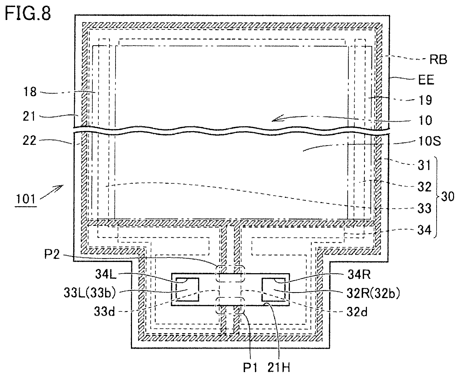

Region RB shown by a hatching in Fig. 8 is located around planar light-emitting element 10, around substrate 31, or around protective film 34. In planar light-emitting module 101 of the comparative example, region RB reaches opening 21H (see the portions surrounded by circles PI, P2), and moisture or other substances easily intrude through the portion where region RB reaches. When planar light-emitting element 10 is sealed by sealing sheets 21, 22, bonding of flat surfaces fails to be achieved, and sufficient sealing performance fails to be obtained.

### [Second Embodiment]

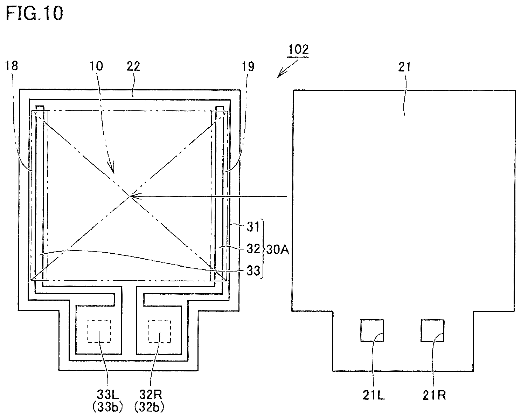

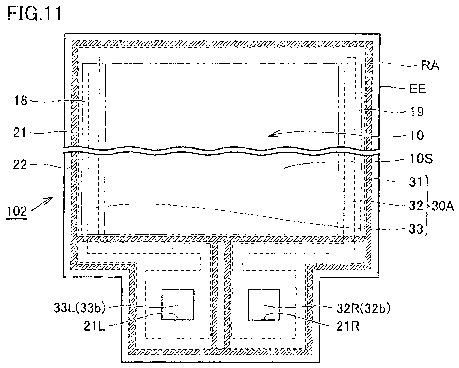

Referring to Fig. 10 and Fig. 11, a planar light-emitting module 102 in a second embodiment will be described. Planar light-emitting module 102 includes a wiring member 30A instead of wiring member 30 (the first embodiment). Wiring member 30A differs from wiring member 30 in that it does not include protective film 34.

Feeding portion 32R in planar light-emitting module 102 is a portion of electrode 32 that is exposable through opening 21R when sealing sheet 21 is disposed on planar light-emitting element 10, substrate 31, and electrode 32. The size of opening 21R is smaller than the size of rectangular portion 32b of electrode 32. When planar light-emitting element 10 is sandwiched and sealed between a pair of sealing sheets 21. 22 from above and below, feeding portion 32R is located on the inside of opening 21R when opening 21R and feeding portion 32R are viewed from the direction parallel to the direction in which planar light-emitting element 10 and sealing sheets 21. 22 are superimposed on each other (when viewed two-dimensionally). In the state in which sealing sheet 21 is disposed on electrode 32, the edge portion that forms opening 21R in sealing sheet 21 is located on a portion having a flat shape in the surface of rectangular portion 32b of electrode 32. The portion around feeding portion 32R in electrode 32 (rectangular portion 32b) is bonded to sealing sheet 21 through adhesive. It is preferable that he portion located around feeding portion 32R in rectangular portion 32b has a surface shape that has little or no step and is as flat as possible (with highest possible flatness).

Feeding portion 33L in planar light-emitting module 102 is a portion of electrode 33 that is exposable through opening 21L when sealing sheet 21 is disposed on planar light-emitting element 10, substrate 31, and electrode 33. The size of opening 21L is smaller than the size of rectangular portion 33b of electrode 33. When planar light-emitting element 10 is sandwiched and sealed between a pair of sealing sheets 21, 22 from above and below, feeding portion 33L is located on the inside of opening 21L when opening 21L and feeding portion 33L are viewed from the direction parallel to the direction in which planar light-emitting element 10 and scaling sheets 21, 22 are superimposed on each other (when viewed two-dimensionally). In the state in which sealing sheet 21 is disposed on electrode 33, the edge portion that forms opening 21L in sealing sheet 21 is located on a portion having a flat shape in the surface of rectangular portion 33b of electrode 32. The portion around feeding portion 33L in electrode 33 (rectangular portion 33b) is bonded to sealing sheet 21 through adhesive. It is preferable that the portion located around feeding portion 33L in rectangular portion 33b has a surface shape that has little or no step and is as flat as possible (with highest possible flatness).

### (Operation and Effects)

Referring to Fig. 11, in planar light-emitting module 102, feeding portions 33L. 32R of electrodes 33, 32 are exposed through openings 21L, 21R, respectively, provided in sealing sheet 21 (first sealing sheet). Contact portions 42, 41 of external wiring 40 (Fig. 1) can be electrically connected to feeding portions 33L, 32R, respectively. External wiring 40 is not located between the end portions of sealing sheets 21, 22. The end portions of sealing sheets 21, 22 can be bonded to each other appropriately, and sealing performance by sealing sheets 21, 22 can be obtained.

Region RA shown by a hatching in Fig. 11 is located around planar light-emitting element 10, around substrate 31, or around protective film 34. Region RA does not reach the outer edge EE (Fig. 11) of sealing sheets 21, 22 or openings 21L, 21R. When sealing sheet 21 is bonded to sealing sheet 22, a sealing structure that contains region RA in the inside by bonding between flat surfaces can be achieved, and therefore it can be said that reduction of sealing performance is suppressed. Planar light-emitting module 102 does not have a configuration having a conductor (electrode pin) inserted (pierced) into the sealing sheet. Reliable sealing performance can be kept for a long time compared with the case of PTD 2.

To sum up the description above, the planar light-emitting module based on an aspect includes a first sealing sheet having an opening, a second sealing sheet bonded to the first sealing sheet, a planar light-emitting element disposed between the first sealing sheet and the second sealing sheet and sealed by the first sealing sheet and the second sealing sheet, and a wiring member disposed between the first sealing sheet and the second sealing sheet and electrically connected to the planar light-emitting element. The wiring member includes a substrate, an electrode formed on the substrate and having an exposed portion disposed so as to be exposable from the opening of the first sealing sheet, and a protective film having an aperture corresponding to the exposed portion and provided so as to cover at least the periphery of the exposed portion of the electrode. One exposed portion described above is exposable through one opening and one aperture described above. An edge portion that forms the opening in the first sealing sheet is located outside the aperture and is located on a portion having a flat shape in a surface of the protective film.

A planar light-emitting module according to another aspect includes a first sealing sheet having an opening, a second sealing sheet bonded to the first sealing sheet, a planar light-emitting element disposed between the first sealing sheet and the second sealing sheet and sealed by the first sealing sheet and the second sealing sheet, and a wiring member disposed between the first sealing sheet and the second sealing sheet and electrically connected to the planar light-emitting element. The wiring member includes a substrate and an electrode formed on the substrate and having an exposed portion disposed so as to be exposable from the opening of the first sealing sheet. One exposed portion described above is exposable through one opening described above. An edge portion that forms the opening in the first scaling sheet is located on a portion having a flat shape in the surface of the electrode.

In the planar light-emitting module, preferably, the first sealing sheet, the second sealing sheet, the planar light-emitting element, and the wiring member have flexibility.

In the configuration above, the portion that forms the opening in the first sealing sheet is bonded to a portion having a flat surface shape (in other words, a portion where steps are not formed). Since a sealing structure can be achieved by bonding between flat surfaces, the configuration above can suppress reduction of sealing performance compared with the conventional sealing structures.

Although embodiments have been described above, the foregoing disclosure is illustrative in all respects and not limitative. The technical scope of the present invention is shown by the claims and it is intended that all equivalents and modifications within the scope of the claims are embraced.

### Reference Signs List

10 planar light-emitting element. 10S front surface, 11 transparent substrate, 12 barrier layer, 13 anode, 14 emissive layer, 15 cathode. 16 sealing member. 17 insulating layer, 18, 19 feeding portion, 21 sealing sheet (first sealing sheet), 21H, 21L, 21R opening. 22 sealing sheet (second sealing sheet). 30, 30A wiring member. 31, 43 substrate, 32, 33 electrode, 32a, 33a linear portion, 32b, 33b rectangular portion, 32c, 33c connecting portion, 32d, 33d step, 32R, 33L feeding portion (exposed portion), 34 protective film, 34L, 34R aperture, 40 external wiring, 41, 42 contact portion, 100, 101, 102 planar light-emitting module, EE outer edge, P1, P2 circle, RA, RB region.

## Claims

1. A planar light-emitting module comprising:
a first sealing sheet having an opening:
a second sealing sheet bonded to said first sealing sheet;
a planar light-emitting element disposed between said first sealing sheet and said second sealing sheet and sealed by said first sealing sheet and said second sealing sheet; and
a wiring member disposed between said first sealing sheet and said second sealing sheet and electrically connected to said planar light-emitting element,
said wiring member including
a substrate,
an electrode formed on said substrate and having an exposed portion disposed so as to be exposable from said opening of said first sealing sheet, and
a protective film having an aperture corresponding to said exposed portion and provided so as to cover at least periphery of said exposed portion of said electrode, wherein
one said exposed portion is exposable through one said opening and one said aperture,
an edge portion that forms said opening in said first sealing sheet is located outside said aperture and located on a portion having a flat shape in a surface of said protective film.

2. A planar light-emitting module comprising:
a first sealing sheet having an opening;
a second sealing sheet bonded to said first sealing sheet;
a planar light-emitting element disposed between said first sealing sheet and said second sealing sheet and sealed by said first sealing sheet and said second sealing sheet; and
a wiring member disposed between said first sealing sheet and said second sealing sheet and electrically connected to said planar light-emitting element,
said wiring member including
a substrate and
an electrode formed on said substrate and having an exposed portion disposed so as to be exposable from said opening of said first sealing sheet, wherein
one said exposed portion is exposable through one said opening, and
an edge portion that forms said opening in said first sealing sheet is located on a portion having a flat shape in a surface of said electrode.

3. The planar light-emitting module according to claim 1 or 2, wherein said first sealing sheet, said second sealing sheet, said planar light-emitting element, and said wiring member have flexibility.
